# EUROPÄISCHE PATENTSCHRIFT

(11) **EP 2 818 032 B1**
(45) Veröffentlichungstag und Bekanntmachung des Hinweises auf die Patenterteilung: **15.07.2020**
(21) Anmeldenummer: 13713063.9
(22) Anmeldetag: 19.02.2013
(51) Int. Cl.: H05K 3/46

(54) **VERFAHREN ZUR HERSTELLUNG EINER LEITERPLATTE UND VERWENDUNG EINES DERARTIGEN VERFAHRENS**
METHOD FOR PRODUCING A CIRCUIT BOARD AND USE OF SUCH A METHOD
PROCÉDÉ DE FABRICATION D'UNE CARTE DE CIRCUITS IMPRIMÉS ET UTILISATION D'UN PROCÉDÉ DE CE TYPE

(30) Priorität: 21.02.2012 AT 622012 U
(43) Veröffentlichungstag der Anmeldung: 31.12.2014
(73) Patentinhaber: AT & S Austria Technologie & Systemtechnik Aktiengesellschaft, 8700 Leoben-Hinterberg (AT)
(72) Erfinder: GÖTZINGER, Siegfried, A-7210 Mattersburg (AT); YAO, ShuYing, Shanghai 201108 (CN); TUOMINEN, Mikael, Shanghai (CN); BECK, Han, Fu Qing City, Fujian Province (CN)
(74) Vertreter: Patentanwaltskanzlei Matschnig & Forsthuber OG
(86) Internationale Anmeldenummer: PCT/AT2013/000029
(87) Internationale Veröffentlichungsnummer: WO 2013/123534

(56) Entgegenhaltungen:
- DE-U1- 20 221 189
- JP-A- H11 150 368
- US-A1- 2003 170 387
- US-A1- 2005 092 519

## Beschreibung

Die vorliegende Erfindung bezieht sich auf ein Verfahren zur Herstellung einer Leiterplatte nach Anspruch 1.

Die Erfindung bezieht sich darüber hinaus auf eine Verwendung eines derartigen Verfahrens.

Im Zusammenhang mit einer Herstellung von mehrlagigen elektronischen Bauteilen, insbesondere mehrlagigen Leiterplatten führt die in den letzten Jahren an Komplexität zunehmende Konstruktion derartiger elektronischer Bauteile allgemein zu einem Erhöhen der Anzahl von Verbindungs- bzw. Anbindungspunkten von aktiven Bauteilen zu Bestandteilen einer Leiterplatte, wobei mit einer zunehmenden Reduktion der Größe gleichzeitig eine Reduktion des Abstands zwischen derartigen Anbindungspunkten vorzusehen ist. Im Zusammenhang mit der Herstellung von Leiterplatten wurde hierbei beispielsweise eine Entflechtung von derartigen Verbindungs- bzw. Anbindungspunkten von Bauteilen über Mikrovias über mehrere Leiterplattenlagen hinweg in sogenannten High Density Interconnects (HDI) vorgeschlagen.

Neben einer zunehmenden Erhöhung der Komplexität des Designs bzw. der Konstruktion von Leiterplatten, beispielsweise im Zusammenhang mit einer Ausbildung von Kavitäten bzw. Hohlräumen und einer damit einhergehenden Miniaturisierung sind zusätzliche Anforderungen im Hinblick auf falz- bzw. biegefähige Verbindungen in einer Leiterplatte entstanden, welche zur Entwicklung einer Hybridtechnik und zum Einsatz sogenannter starr-flexibler Leiterplatten führten. Derartige starr-flexible Leiterplatten, welche aus starren Bereichen bzw. Teilbereichen der Leiterplatte sowie derartige starre Bereiche verbindenden, flexiblen Bereichen bestehen, erhöhen die Zuverlässigkeit, bieten weitere bzw. zusätzliche Möglichkeiten einer Freiheit des Designs bzw. der Konstruktion und ermöglichen weitere Miniaturisierungen.

Im Zusammenhang mit der Herstellung von starr-flexiblen Leiterplatten sind darüber hinaus unterschiedliche Verfahren bekannt, wobei nach einem Aufbau einer Leiterplatte, welche starre und flexible Teilbereiche enthält, welche miteinander verbunden sind bzw. werden, ein Entfernen von üblicherweise über einem freizulegenden flexiblen Teilbereich befindlichen Schichten bzw. Lagen vorgenommen wird, in diesem Zusammenhang wird beispielsweise auf die JP-A 2004031682, die JP-A 2003198133, die US-PS 4931134 oder die US-A 2009/0026168 verwiesen, insbesondere in der letztgenannten Literaturstelle ist ein Verfahren geoffenbart, wobei nach einem Bereitstellen wenigstens eines flexiblen Teilbereichs und wenigstens eines starren Teilbereichs der herzustellenden Leiterplatte, wobei der flexible und der starre Teilbereich miteinander verbunden werden, weitere Schichten bzw. Lagen der herzustellenden Leiterplatte aufgebaut werden und nach einem Fertigstellen des Aufbaus der flexible Teilbereich unter Verwendung eines über dem flexiblen Teilbereich vorzusehenden Hohlraums freigelegt wird. Bei der bekannten Ausführungsform gemäß der US-A 2009/0026188 wird ein Hohlraum über dem nachträglich freizulegenden flexiblen Teilbereich durch eine Kupferschicht abgedeckt, worauf nach Fertigstellung der Leiterplatte an den Endbereichen des freizulegenden flexiblen Teilbereichs beispielsweise durch einen Laser Einschnitte bis zu der den Hohlraum abdeckenden Kupferschicht ausgebildet werden und dann eine Entfernung der Kupferschicht zur endgültigen Freilegung des flexiblen Teilbereichs unter Einsatz einer ätzenden Lösung erfolgt, welche nach Durchtrennung der Kupferschicht unmittelbar auf die Oberfläche des flexiblen Teilbereichs trifft. Um eine Beschädigung des derart freizulegenden flexiblen Teilbereichs zu vermeiden, muss bei der bekannten Ausführungsform gemäß der US-A 2009/0028168 zusätzlich eine Abdeckschicht über dem flexiblen Teilbereich vorgesehen sein, wobei eine derartige Abdeckschicht beispielsweise für eine nachfolgende Kontaktierung im flexiblen Bereich oder für eine Anordnung entsprechender Bauelemente wieder aufwändig entfernt werden muss. Bei einem Verzicht auf die Abdeckschicht würde jedoch bei Einsatz der ätzenden Lösung zur Freilegung des flexiblen Teilbereichs unmittelbar eine Beschädigung von gegebenenfalls auf der Oberfläche des flexiblen Teilbereichs freiliegenden Strukturen oder Bauteilen erfolgen, so dass gemäß diesem bekannten Stand der Technik nicht auf die aufwändigen zusätzlichen Schritte eines Aufbringens einer entsprechenden Abdeck- bzw. Schutzschicht und einer nachfolgenden wenigstens teilweisen Entfernung derselben verzichtet werden kann.

Zur Vermeidung einer Verbindung zwischen miteinander zu verbindenden Schichten bzw. Lagen oder im Wesentlichen flächigen Elementen einer Leiterplatte in einem Teilbereich, welcher nachfolgend freigelegt werden soll, ist es darüber hinaus beispielsweise bekannt, Folien, welche Hafteigenschaften aufweisen, entsprechend vorzukonfektionieren, so dass Teilbereiche der Folien, welche während des Verbindungsvorgangs ein Anhaften der miteinander zu verbindenden Materialschichten bereitstellen sollen, mit Ausnehmungen versehen werden. Alternativ können neben im Wesentlichen vollflächigen Klebefolien entsprechend dem nachträglich zu entfernenden Teilbereich vorkonfektionierte Trennfolien eingesetzt werden. Es ist unmittelbar einsichtig, dass eine derartige Vorkonfektionierung derartiger Verbindungsfolien bzw. Klebefolien und/oder Trennfolien mit entsprechend hohem Aufwand verbunden ist und darüber hinaus entsprechend hohe Anforderungen an eine Registrierung bzw. Ausrichtung der miteinander zu verbindenden Materialschichten unter Zwischenschaltung derartiger, insbesondere vorkonfektionierter Folien stellt.

Beispielsweise ist dazu aus dem Dokument JP 11150368 A ein solches Verfahren zur Herstellung einer Leiterplatte bekannt geworden, bei dem eine vorkonfektionierte Klebeschicht mit vorbereiteten Öffnungen bzw. Freistellungen zum Verkleben einzelner Lagen der Leiterplatte verwendet wird. Die vorbereiteten Öffnungen bzw. Freistellungen in der Klebeschicht dienen dazu, um später nach dem Verkleben die im Bereich der Freistellungen der Klebeschicht gelegenen nicht verklebten Teilbereiche der Leiterplatte entfernen zu können. Dabei auftretende Schlitze in der Leiterplatte müssen mit einem separaten, externen Füllmaterial, dass von außen mittels einer Düse in die zu verfüllenden Schlitze der Leiterplatte eingespritzt wird, verfüllt werden.

US 2005/092519 A1 offenbart das Aufbringen eines ein Anhaften verhindernden Materials auf einem freizulegenden Bereich eines ersten Elements, es offenbart aber nicht das direkte Aufbringen einen weiteren vollflächigen Lage auf dem ersten Element.

Neben der oben beschriebenen Herstellung von starr-flexiblen Leiterplatten, wobei ein flexibler Leiterplattenbereich nach Durchführung gegebenenfalls einer Mehrzahl von Be- bzw. Verarbeitungsschritten wiederum freizulegen ist, ist es auch bekannt, im Inneren einer Leiterplatte befindliche Elemente oder Bauteile, wie beispielsweise aktive oder passive elektronische Bauteile nach Durchführung einer Mehrzahl von Be- bzw. Verarbeitungsschritten wiederum freizulegen oder Hohlräume im Inneren einer derartigen Leiterplatte zur Verfügung zu stellen.

Anstelle eines Einsatzes von vorkonfektionierten Klebefolien und insbesondere zur einfachen Freistellung bzw. Freilegung von Teilbereichen ist ein Verfahren der eingangs genannten Art beispielsweise aus der WO 2008/098271 bekannt geworden, wobei durch Einsatz eines ein Anhaften verhindernden oder ein nachträgliches Entfernen erleichternden Materials auf einer Schicht bzw. Lage oder einem Element der herzustellenden Leiterplatte, welches nachfolgend freigelegt werden soll, die Ausbildung derartiger Freistellungen oder die Freilegung von flexiblen Teilbereichen stark vereinfacht wurde.

Bei einem derartigen Entfernen von Teilbereichen einer weiteren Lage, welche mit einem ersten Element oder einer ersten Schicht, beispielsweise einem Core-Element der herzustellenden Leiterplatte verbunden, beispielsweise verpresst oder laminiert wurde, war es insbesondere erforderlich, entsprechend dem freizulegenden bzw. freizustellenden Teilbereich die zusätzlich angeordneten weiteren Lagen entsprechend zu durchtrennen, wobei dies beispielsweise unter Einsatz eines Laserschneidens erfolgte. Um ein unbeabsichtigtes Beschädigen von Teilbereichen der Leiterplatte zu vermeiden und insbesondere die Eintrittstiefe eines Lasers bei einem Laserschneiden zu begrenzen, mussten üblicherweise in derartige Leiterplatten zusätzliche metallische Schichten, beispielsweise Kupferschichten eingebracht werden, welche als Begrenzungsschicht für das Laserschneiden dienten, wie dies beispielsweise auch der WO 2011/088489 entnehmbar ist. Neben dem zusätzlichen Aufwand einer Herstellung derartiger ergänzender Begrenzungs- bzw. Stoppschichten für ein nachfolgendes Laserschneiden verhindern derartige Schichten bzw. Strukturen beispielsweise das Vorsehen von leitenden Strukturen auf dem ersten oder Core-Element, welche die Grenze zwischen dem freizulegenden Teilbereich und dem nicht freizulegenden Teilbereich überdecken, da unmittelbar einsichtig ist, dass durch Vorsehen einer durchgehenden leitenden bzw. metallischen Schicht als Laserstoppschicht derartige Strukturen kurzgeschlossen werden , so dass aufwändige zusätzliche Kontaktierungen in einem derartigen Fall erforderlich waren.

Darüber hinaus ist für eine Mehrzahl von bei der Herstellung von Leiterplatten eingesetzten Materialien, insbesondere nicht-leitenden Kunststoffmaterialien bei derartigen Freistellungen die Herstellung von genau bzw. scharf begrenzten Kanten nicht möglich, da insbesondere bei weiteren Verarbeitungsschritten unter gegebenenfalls erhöhter Temperatur und/oder erhöhtem Druck derartige Kunststoffmaterialien einer Verformung unterliegen und somit genau definierte Randbereiche von freigestellten Teilbereichen nicht bzw. nur aufwändig herstellbar sind. Zu diesem Zweck müssen beispielsweise kostspielige Materialien geringer Fließfähigkeit eingesetzt werden oder es sind zusätzliche Konturierungsschritte, wie beispielsweise Ätzschritte zur Bereitstellung von geradlinigen Kanten- bzw. Randbereichen vorzusehen, welche insgesamt zu einem erhöhten Auffand bei einer Herstellung derartiger Leiterplatten führen.

Darüber hinaus ist die Verwendung von mit Verstärkungen, beispielsweise Fasern, insbesondere Glasfasern versehenen Kunststoffmaterialien zur Erzielung entsprechender mechanischer Festigkeiten vorgesehen, wobei derartige Verstärkungen einen zusätzlichen Aufwand bei einem Durchtrennen nach einer Verbindung mit weiteren Schichten bzw. Lagen einer Leiterplatte bedingen und derart ebenfalls zu einem erhöhten Aufwand bei der Herstellung einer Leiterplatte führen.

Die vorliegende Erfindung zielt daher darauf ab, ein Verfahren zur Herstellung einer Leiterplatte der eingangs genannten Art sowie eine Verwendung eines derartigen Verfahrens zur Verfügung zu stellen, wobei die oben erwähnten Nachteile des bekannten Standes der Technik bei der Ausbildung von Freistellungen bzw. einer Entfernung von Teilbereichen wenigstens einer Schicht bzw. Lage einer mehrlagigen Leiterplatte vermieden oder zumindest weitgehend reduziert werden können. Hierbei zielt die Erfindung insbesondere darauf ab, derartige freigestellte Teilbereiche nicht nur mit einem reduzierten Verfahrens- bzw. Herstellungsaufwand bereitzustellen, sondern auch entsprechend scharf bzw. genau definierte Rand- bzw. Kantenbereiche insbesondere ohne Einsatz von speziellen und üblicherweise kostspieligen Materialien und ohne Einsatz von zusätzlichen Verfahrensschritten zu ermöglichen.

Zur Lösung dieser Aufgaben ist ein Verfahren mit den Merkmalen von Anspruch 1 vorgeschlagen. Erfindungsgemäß wird nach den eingangs genannten Verfahrensschritten in der weiteren Lage entsprechend dem nachfolgend zu entfernenden Teilbereich an wenigstens einem Rand des zu entfernenden Teilbereichs ein Durchtrennen des Materials der weiteren Lage vor einem Aufbringen auf das erste Element und/oder Verbinden mit demselben durchgeführt.

Dadurch, dass erfindungsgemäß in der weiteren Lage entsprechend dem zu entfernenden Teilbereich an wenigstens einem Rand desselben eine Durchtrennung vor einer Verbindung mit dem ersten Element, beispielsweise Core-Element durchgeführt wird, kann in einem einfach und insbesondere getrennt durchzuführenden Verfahrensschritt der nachträglich zu entfernende Teilbereich bzw. ein Rand- bzw. Kantenbereich desselben wenigstens teilweise in der weiteren Lage vorbereitet werden, worauf nach einer Anordnung auf dem ersten Element und/oder Verbindung mit demselben im Wesentlichen eine Sollbruchstelle für ein nachfolgendes Entfernen des zu entfernenden Teilbereichs zur Verfügung gestellt wird. Dieser durchtrennte Bereich lässt sich beispielsweise bei Herstellung einer starr-flexiblen Leiterplatte durch ein Biegen desselben im Wesentlichen ohne weitere Verfahrensschritte durchbrechen und kann somit in einfacher Weise durchtrennt werden. Hierbei lassen sich genau definierte Rand- bzw. Kantenbereiche des nachfolgend herzustellenden Teilbereichs definieren und zur Verfügung stellen, so dass auf aufwändige zusätzliche Bearbeitungsschritte derartiger Rand- bzw. Kantenbereiche ebenfalls verzichtet werden kann. Weilers kann durch ein Vorsehen eines vorab durchtrennten Bereichs sichergestellt werden, dass darunterliegende Elemente oder beispielsweise Bauteile nicht durch entsprechende zusätzliche Maßnahmen geschützt werden müssen, da insbesondere für ein Durchtrennen beispielsweise durch ein Laserschneiden auch nicht zusätzliche Abdeck- bzw. Sperrschichten aus einem leitenden Material vorgesehen werden müssen. Durch einen Verzicht auf derartige zusätzliche Strukturen aus einem leitenden Material kann darüber hinaus die Ausbildung von leitenden Strukturen auf dem ersten Element vorgesehen werden, welche sich über die Grenzfläche zwischen dem zu entfernenden Teilbereich und nicht entfernten Bereichen erstrecken, so dass auch vereinfachte und insbesondere diese Grenzfläche überdeckende, leitende Strukturen zur Verfügung gestellt werden können.

Weiters kann durch ein Füllen des durchtrennten Bereichs mit einem entsprechend einfach entfernbaren Material der Entfernungsvorgang des zu entfernenden Teilbereichs vereinfacht werden und es kann durch ein derartiges Verfüllen des durchtrennten Bereichs auch sichergestellt werden, dass unterhalb dieses durchtrennten Bereichs liegende Strukturen während nachfolgender Be- bzw. Verarbeitungsschritte nach einem Aufbringen der weiteren Lage entsprechend sicher geschützt sind.

Zur Erleichterung eines Entfernens des zu entfernenden Teilbereichs wird gemäß einer bevorzugten Ausführungsform vorgeschlagen, dass wenigstens an zwei einander gegenüberliegenden Rändern des zu entfernenden, im Wesentlichen rechteckigen Teilbereichs das Material der weiteren Lage durchtrennt wird. Derart kann eine Mehrzahl von Sollbruchstellen zur Verfügung gestellt werden, wobei weitere bzw. restliche Randbereiche des zu entfernenden Teilbereichs, welche insbesondere entfernt von zu schützenden darunter liegenden Strukturen angeordnet sind und entsprechend einfach mit bekannten Mitteln ebenfalls durchtrennt werden können, vorgesehen werden.

Erfindungsgemäß wird das Material der weiteren Lage von einem mit einer Verstärkung ausgebildeten, fließfähigen Kunststoffmaterial, insbesondere einem mit Glasfasern verstärkten fließfähigen Kunststoffmaterial, beispielsweise einem Prepreg Material, gebildet, wobei der durchtrennte Bereich der weiteren Lage durch das fließfähige Kunststoffmaterial gefüllt wird. Durch Vorsehen der Verstärkungen kann ein entsprechend widerstandsfähiges Material der weiteren Schicht bzw. Lage zur Verfügung gestellt werden, während in dem durchtrennten Bereich zum Schutz von insbesondere darunter liegenden Strukturen ein Kunststoffmaterial ohne Verstärkung vorgesehen wird, welches nachfolgend ein entsprechend vereinfachtes Trennen des zu entfernenden Teilbereichs in dem bereits durchtrennten Bereich ermöglicht.

Nach Herstellung der Durchtrennung der weiteren Lage kann vor einer Verbindung mit dem ersten Element ein Verfüllen des eine Sollbruchstelle bildenden Bereichs mit einem entsprechenden Material vorgenommen werden.

Erfindungsgemäß wird der durchtrennte Bereich der weiteren Lage während des Verbindungsvorgangs mit dem ersten Element der Leiterplatte durch das fließfähige Kunststoffmaterial der an den durchtrennten Bereich anschließenden Teilbereiche der weiteren Lage durch die während des Verbindungsvorgangs auftretenden Bedingungen erhöhter Temperatur und/oder erhöhten Drucks gefüllt. Derart werden Verformungs- bzw. Fließeigenschaften für derartige nicht-leitende Lagen unter Bedingungen erhöhter Temperatur und/oder erhöhten Drucks ausgenutzt, um während des Verbindungsvorgangs mit dem ersten Element unmittelbar ein Füllen des durchtrennten Bereichs für einen Schutz darunter liegender Strukturen zu ergeben.

Zur Erzielung genau definierter Rand- bzw. Kantenstrukturen sowie zur einfachen Durchführung der Durchtrennung des Rand- bzw. Kantenbereichs der weiteren Lage wird darüber hinaus vorgeschlagen, dass das Durchtrennen der weiteren Lage an wenigstens einem Rand des zu entfernenden Teilbereichs durch ein Fräsen, Ritzen, Stanzen, Schlitzen, Schneiden, insbesondere Laserschneiden durchgeführt wird, wie dies einer weiters bevorzugten Ausführungsform des erfindungsgemäßen Verfahrens entspricht.

Wie oben bereits angedeutet, kann ein einfaches Lösen des zu entfernenden Teilbereichs dadurch vorgenommen werden, dass nach einem Verbinden der weiteren Lage und des ersten Elements der zu entfernende Teilbereich durch ein Brechen des durchtrennten Bereichs der weiteren Lage entfernt wird, wie dies einer bevorzugten Ausführungsform des erfindungsgemäßen Verfahrens entspricht.

Alternativ oder zusätzlich kann weiters erfindungsgemäß bevorzugt vorgesehen sein, dass nach einem Verbinden der weiteren Lage mit dem ersten Element das im durchtrennten Bereich der weiteren Lage angeordnete Material durch ein Schneiden, insbesondere ein Laserschneiden mit einem CO₂₋Laser wenigstens teilweise durchtrennt wird.

Zur Herstellung entsprechender mehrlagiger Leiterplatten wird darüber hinaus gemäß einer weiters bevorzugten Ausführungsform vorgeschlagen, dass auf der weiteren Lage aus dem nicht-leitenden Material wenigstens eine Lage bzw. Schicht aus einem leitenden, insbesondere strukturierten Material vorgesehen wird.

Gemäß einer weiters bevorzugten Ausführungsform wird darüber hinaus vorgeschlagen, dass das erste Element, der herzustellenden Leiterplatte von einem flexiblen Material zur Herstellung einer starr-flexiblen Leiterplatte gebildet wird, wobei weitere Vorteile des erfindungsgemäßen Verfahrens bei einem Einsatz im Zusammenhang mit der Herstellung von starr-flexiblen Leiterplatten teilweise bereits oben angeführt wurden.

Gemäß einer weiters bevorzugten Ausführungsform wird vorgeschlagen, dass das erste Element auf beiden Oberflächen mit wenigstens einer weiteren Lage verbunden wird, wobei nachfolgend jeweils einander gegenüberliegende Teilbereiche der weiteren Lagen entfernt werden, so dass insbesondere in gemeinsamen Verbindungsschritten, wie beispielsweise Laminierschritten, gleichzeitig ein Aufbau unter Einsatz mehrerer Schichten bzw. Lagen erfolgen kann.

Wie bereits mehrfach erwähnt, kann das erfindungsgemäße Verfahren insbesondere zur Herstellung einer mehrlagigen Leiterplatte eingesetzt bzw. verwendet werden.

Weitere bevorzugte Verwendungsmöglichkeiten des erfindungsgemäßen Verfahrens liegen in einer Erzeugung wenigstens eines Kanals in einer Leiterplatte, einer Freistellung zur Erzeugung von Hohlräumen, insbesondere dreidimensionalen Hohlräumen bzw. Kavitäten in einer Leiterplatte, einer Herstellung von abgesetzten und/oder stufenförmig ausgebildeten Teilbereichen einer Leiterplatte, einer Freistellung wenigstens eines Elements, insbesondere Registrierelements, oder eines Bauteils im inneren bzw. in Innenlagen einer mehrlagigen Leiterplatte und/oder einer Herstellung einer starr-flexiblen Leiterplatte.

Die Erfindung wird nachfolgend anhand von in der beiliegenden Zeichnung schematisch dargestellten Ausführungsbeispielen des erfindungsgemäßen Verfahrens zur Herstellung einer Leiterplatte näher erläutert. In dieser zeigen:
Fig. 1 einen schematischen Teilschnitt durch ein erstes Element bzw. Core-Element einer gemäß dem erfindungsgemäßen Verfahren herzustellenden Leiterplatte;
Fig. 2 ebenfalls einen Teilschnitt in einem nachfolgenden Verfahrensschritt, wobei das in Fig. 1 dargestellte Core-Element mit einer Mehrzahl von weiteren Schichten bzw. Lagen entsprechend dem erfindungsgemäßen Verfahren verbunden wurde;
Fig. 3 einen Teilschnitt ähnlich zu Fig. 2, wobei entsprechend dem erfindungsgemäßen Verfahren ein Teilbereich der weiteren Lagen zur Freilegung bzw. Freistellung eines Bereichs des Core-Elements wiederum entfernt wurde;
Fig. 4 eine schematische Darstellung einer ersten Ausführungsform einer Durchtrennung eines Rand- bzw. Kantenbereichs eines zu entfernenden Teilbereichs der weiteren Lage vor einem Verbinden mit dem Core- Element entsprechend dem erfindungsgemäßen Verfahren;
Fig. 5, 6 Schnittdarstellungen entsprechend Fig. 4 von weiteren Ausführungsformen einer Durchtrennung eines Rand- bzw. Kantenbereichs eines zu entfernenden Teilbereichs der weiteren Lage entsprechend dem erfindungsgemäßen Verfahren;
Fig. 7 eine schematische Darstellung einer Durchtrennung eines gefüllten, vorab durchtrennten Rand- bzw. Kantenbereichs des zu entfernenden Teilbereichs gemäß dem erfindungsgemäßen Verfahren;
Fig. 8 einen schematischen Teilschnitt ähnlich der Darstellung zu Fig. 2 durch eine abgewandelte Ausführungsform, wobei entsprechend dem erfindungsgemäßen Verfahren ein Core-Element auf beiden Seiten mit wenigstens einer weiteren Lage insbesondere zur Herstellung einer starr-flexiblen Leiterplatte verbunden wurde;
Fig. 9 in einer zu Fig. 8 ähnlichen Darstellung einen Teilschnitt durch eine weitere abgewandelte Ausführungsform zur Durchführung des erfindungsgemäßen Verfahrens bei der Herstellung einer wiederum starr-flexiblen Leiterplatte; und
Fig. 10 einen schematischen Teilschnitt durch die Ausführungsform gemäß Fig. 9 nach der Entfernung der zu entfernenden Teilbereiche der weiteren Schichten bzw. Lagen, In Fig. 1 ist schematisch mit 1 ein Teilbereich eines ersten Elements bzw. Core-Elements 1 einer herzustellenden Leiterplatte bezeichnet, wobei das Core-Element im Wesentlichen aus einer Schicht bzw. Lage 2 aus einem nicht-leitenden Material und auf beiden Oberflächen aus Lagen 3 und 4 aus einem leitenden Material besteht, wobei zumindest die obere Schicht bzw. Lage 4 strukturiert ausgebildet ist.

Darüber hinaus kann das Core bzw. Core-Element selbst eine mehrlagige Leiterplatte sein, wobei sämtliche Lagen des Core-Elements entsprechend üblichen bzw. bekannten Ausbildungen miteinander beispielsweise über Laser Vias, Durchtritts-Öffnungen oder dgl. verbunden sein können, welche jedoch zur Vereinfachung der Darstellung nicht näher gezeigt sind.

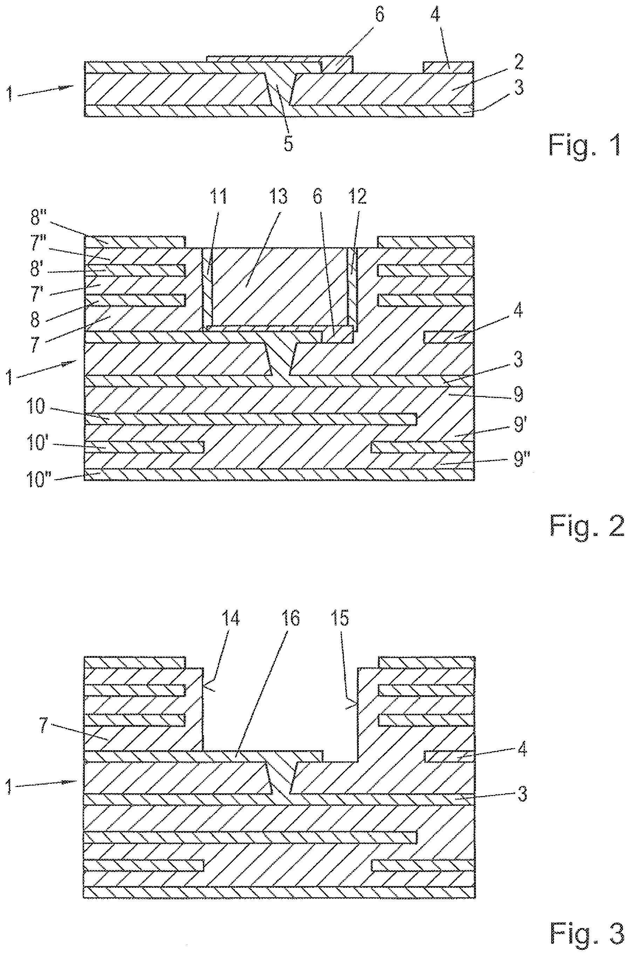

Darüber hinaus ist in Fig. 1 eine Durchkontaktierung 5 angedeutet.

Auf einem Teilbereich des Core-Elements 1 ist ein ein Anhaften verhinderndes oder ein nachträgliches Entfernen erleichterndes Material 6 aufgebracht, welches, wie dies aus den nachfolgenden Darstellungen ersichtlich werden wird, ein unmittelbares Anhaften wenigstens einer weiteren Schicht bzw. Lage bei dem weiteren Aufbau der herzustellenden Leiterplatte entsprechend einem nachfolgend freizulegenden Teilbereich verhindern wird.

Bei der Darstellung gemäß Fig. 2 ist ersichtlich, dass das Core-Element 1 auf beiden Seiten jeweils mit einer Mehrzahl von Schichten bzw. Lagen 7, 7' und 7" aus jeweils einem nicht-leitenden Material sowie darüber hinaus angedeuteten leitenden Schichten bzw. Lagen 8, 8' und 8" abgedeckt und mit diesen beispielsweise durch ein Laminieren oder Verpressen verbunden ist.

Ebenso sind weitere Schichten bzw. Lagen aus einem nicht-leitenden Material 9,9' und 9" sowie einem leitenden Material 10,10' und 10" angedeutet.

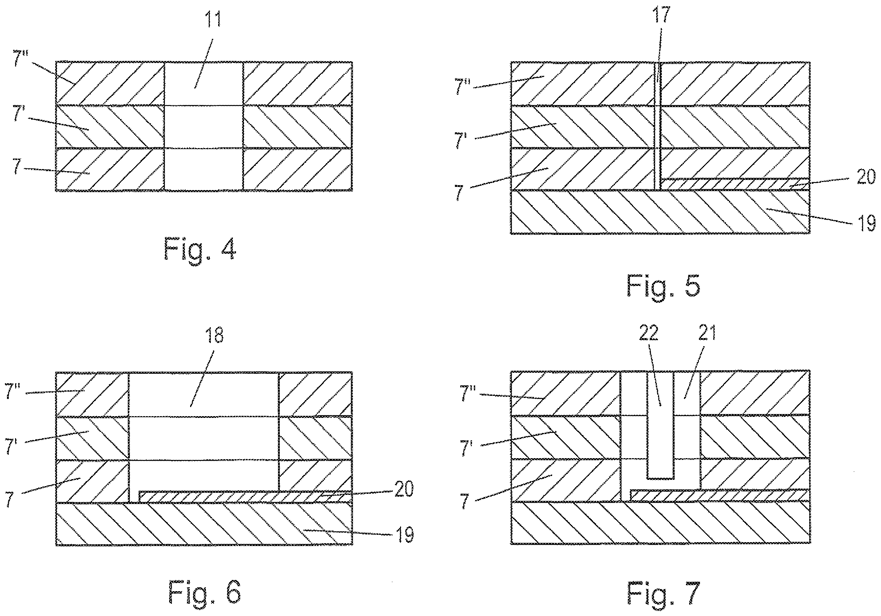

Ein über dem Material 6, welches ein Anhaften verhindert oder ein nachfolgendes Entfernen erleichtert, angeordneter Teilbereich der weiteren Schichten bzw. Lagen 7, 7' und 7" weist entsprechend den Randbereichen des Materials 6 jeweils einen durchtrennten Bereich 11 und 12 auf, wie dies insbesondere anhand der Figuren 4 bis 6 näher im Detail erörtert werden wird. Diese durchtrennten Rand- bzw. Kantenbereiche 11, 12 sind nach einem Durchtrennen mit einem von dem Material der anschließenden Bereiche der Lagen 7, 7' und 7" aus nicht-leitendem Material insbesondere verschiedenen Material gefüllt, wobei diese Randbereiche 11 und 12 ein nachfolgendes Entfernen des zu entfernenden Teilbereichs 13 erleichtern bzw. unmittelbar durch ein Brechen ein Entfernen des Bereichs 13 sicherstellen. Gegebenenfalls kann auch ein gleiches bzw. gleichartiges nicht-leitendes Material verwendet werden.

Die Situation nach einem Entfernen dieses Teilbereichs 13 ist in Fig. 3 dargestellt. Es ist ersichtlich, dass durch ein Bereitstellen der durchtrennten Bereiche 11 und 12 scharfkantige, verbleibende Rand- bzw. Kantenbereiche 14 und 15 zur Verfügung gestellt werden, welche insbesondere ohne aufwändige zusätzliche Bearbeitungsschritte, wie beispielsweise Ätzschritte erzielbar sind. Darüber hinaus kann durch Vorsehen der durchtrennten Rand- bzw. Kantenbereiche 11 und 12 auf ein Ausbilden von Abdeck- bzw. Stoppschichten beispielsweise für ein Laserschneiden für ein Entfernen des zu entfernenden Teilbereichs 13 verzichtet werden, so dass, wie dies deutlich aus Fig. 3 ersichtlich ist, auch leitende Strukturen 16 zur Verfügung gestellt werden können, welche ausgehend von dem durch die Schichten 7 und 8 abgedeckten Teilbereich sich in den in Fig. 3 dargestellten freigelegten Teilbereich erstrecken. Derart kann die Strukturierung von leitenden Elementen 16 insbesondere des Core-Elements 1 vereinfacht werden, da derartige leitende Strukturen 16 unmittelbar in freizustellende Bereiche vorragen können.

In Fig. 4 ist in vergrößertem Maßstab ein Ausschnitt entsprechend dem durchtrennten Teilbereich 11 der Darstellung von Fig. 2 im Detail gezeigt, wobei leitende Strukturen zwischen den einzelnen Schichten 7, 7' und 7" zur Vereinfachung der Darstellung nicht gezeigt sind. Eine derartige Durchtrennung 11 erfolgt vor einem Verbinden der weiteren Lagen 7, 7' und 7" mit dem Core-Element 1 gemäß der Ausführungsform der Fig. 1 bis 3 beispielsweise durch ein Schneiden, Stanzen, Fräsen, Ritzen oder dgl. Der durchtrennte Teilbereich 11 wird in weiterer Folge entweder unmittelbar vor einem Verbinden mit dem Core-Element 1 mit einem von dem Material der Schichten bzw. Lagen 7,7' und 7" verschiedenen Material gefüllt oder wird während des Verbindungsvorgangs mit dem Core-Element 1 insbesondere unter Bedingungen erhöhter Temperatur und/oder erhöhten Drucks beispielsweise durch ein Fließen von Harzmaterial oder Kunststoffmaterial der Lagen 7, 7' bzw. 7" gefüllt. Hierbei weisen die Lagen 7, 7' und 7" beispielsweise Verstärkungen, insbesondere Glasfasern auf, während in den durchtrennten Bereich 11 insbesondere bei einem Füllen durch erhöhten Druck und/ oder erhöhte Temperatur lediglich das fließfähige Harz bzw. Kunststoffmaterial eindringt, welches in weiterer Folge beispielsweise durch ein einfaches Brechen im Bereich der durchtrennten Bereiche 11 , 12 ein leichtes Entfernen des zu entfernenden Teilbereichs 13 ermöglicht.

In Fig. 5 und 6 sind weitere abgewandelte Ausführungsformen einer Herstellung von durchtrennten Rand- bzw. Kantenbereichen angedeutet, welche mit 17 und 18 bezeichnet sind.

In Übereinstimmung mit der in Fig. 4 dargestellten Ausführungsform werden die Schichten bzw. Lagen aus nicht-leitendem Material wiederum mit 7, 7' und 7" bezeichnet, wobei ein gegebenenfalls von einer mehrlagigen Leiterplatte gebildetes Core 19 angedeutet ist, auf welchem eine Ablöseschicht 20 aus dem ein Anhaften verhindernden Material angedeutet ist. Zur Vereinfachung der Darstellung sind die mehreren Lagen des Core-Elements 19 nicht getrennt bzw. detailliert gezeigt.

Während bei der Darstellung gemäß Fig. 5 ein eine sehr geringe Dicke bzw. Breite aufweisender durchtrennter Bereich 17 gezeigt ist, welcher beispielsweise durch ein Schneiden mit einem Messer oder ein Stanzen hergestellt werden kann, ist bei der Ausführungsform gemäß Fig. 6 ersichtlich, dass der durchtrennte Bereich 18 eine entsprechend einem unterschiedlichen Einsatzzweck vergleichsweise große Breite bzw. Dicke aufweist.

Bei der Darstellung gemäß Fig. 7 ist angedeutet, dass ein durchtrennter Bereich 21 beispielsweise nach einer Verbindung mit dem Core-Element anstelle eines einfachen Brechens beispielsweise durch einen Laser durchtrennt bzw. geschnitten wird, wie dies mit 22 angedeutet ist. Insbesondere aufgrund der Tatsache, dass ähnlich wie bei vorangehenden Ausführungsformen der durchtrennte Bereich 21 mit einem insbesondere von Verstärkungen freien Material gefüllt ist, kann ein derartiger Laserschneidvorgang mit entsprechend höherer Geschwindigkeit und/oder geringerer Leistung durchgeführt werden. Alternativ kann ein tiefenkontrolliertes Laserschneiden mit UV vorgesehen sein.

Darüber hinaus lassen sich durch die Abwesenheit von Verstärkungen in den vorab durchtrennten Bereichen 17, 18 und 21 wiederum genau definierte und scharfkantige Rand- bzw. Kantenbereiche nach einem Entfernen des zu entfernenden Teilbereichs zur Verfügung stellen, wie dies in Fig. 3 deutlich dargestellt ist.

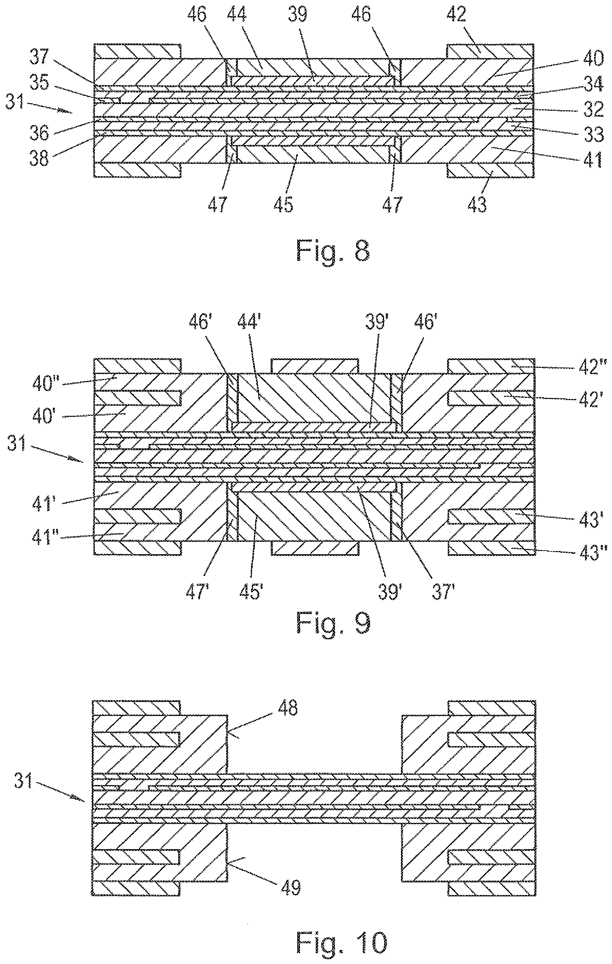

In Fig. 8 ist eine abgewandelte Ausführungsform einer herzustellenden Leiterplatte gezeigt, wobei ein mit 31 bezeichnetes wiederum mehrlagiges Core-Element ähnlich wie bei der Ausführungsform gemäß Fig. 1 bis 3 wenigstens mit einer nicht-leitenden Lage 32 und leitenden und insbesondere strukturierten Lagen 35 und 36 versehen ist und zur Herstellung einer starr-flexiblen Leiterplatte eingesetzt wird. Dieses Core-Element 31 ist beidseitig mit einer Abdeckschicht 37 und 38 abgedeckt worden, wobei Klebeschichten mit 33 und 34 angedeutet sind.

Entsprechend einem freizulegenden Teilbereich des flexiblen Core-Elements 31 sind wiederum Bereiche aus einem ein Anhaften verhindernden Material 39 vorgesehen, wobei mit dem Core-Element 31 auf beiden Seiten jeweils eine Lage 40 und 41 aus einem nicht-leitenden Material verbunden wird. Auf diesen Lagen 40 und 41 sind darüber hinaus insbesondere strukturierte leitende Lagen 42 und 43 angedeutet.

Ähnlich wie bei der vorangehenden Ausführungsform weisen die nachfolgend zu entfernenden Teilbereiche 44 und 45 Rand- bzw. Kantenbereiche 46 und 47 auf, welche durchtrennt und durch ein von dem Material der anschließenden Lagen 40 und 41 verschiedenes Material gefüllt sind.

In ähnlicher Weise ist Fig. 9 eine abgewandelte Ausführungsform einer herzustellenden starr-flexiblen Leiterplatte zu entnehmen, wobei mit einem wiederum mit 31 bezeichneten Core-Element eine Mehrzahl von Lagen 40', 40", 41' und 41" verbunden ist bzw. wird, wobei Lagen aus einem leitenden Material mit 42', 42", 43' und 43" bezeichnet sind.

Ähnlich wie bei der in Fig. 8 dargestellten Ausführungsform sind Bereiche 39' des Core-Elements 31 mit dem ein Anhaften verhindernden Material beschichtet, wobei zu entfernende Teilbereiche 44' und 45' wiederum durchtrennte Rand- bzw. Kantenbereiche 46' und 47' aufweisen.

Nach einem Entfernen dieser zu entfernenden Teilbereiche 44' und 45', wie dies in Fig. 10 dargestellt ist, ergeben sich ähnlich wie bei einer Ausführungsform gemäß den Fig. 1 bis 3 wiederum genau definierte und scharfkantige Rand- bzw. Kantenbereiche 48, 49, wobei ein Entfernen dieser zu entfernenden Teilbereiche durch einfaches Brechen derselben im Bereich der Durchtrennungen 46' und 47' erfolgen kann. Alternativ werden beispielsweise die durchtrennten Bereiche sowie das darin befindliche ein gefüllte Material mit einem einfachen Schneidvorgang, beispielsweise Laserschneidvorgang durchtrennt, wie dies in Fig. 7 angedeutet ist.

In sämtlichen der vorangehenden Ausführungsformen können somit in einfacher und zuverlässiger Weise genau definierte Rand- bzw. Kantenbereiche von freizulegenden Teilbereichen einer mehrlagigen Leiterplatte zur Verfügung gestellt werden, wobei insbesondere auf aufwändige Nachbehandlungsschritte zur Bereitstellung derartiger genau definierter Kantenbereiche verzichtet werden kann. Dies gelingt durch eine Ausbildung von durchtrennten Bereichen der wenigstens einen weiteren Lage, welche mit einem ersten Element bzw. Core-Element 1, 19, 31 der herzustellenden Leiterplatte zu verbinden ist. und durch ein Füllen mit einem von dem Material dieser weiteren Lage verschiedenen Material, wobei dies im Wesentlichen eine Sollbruchsteile für das nachfolgende Entfernen des zu entfernenden Teilbereichs zur Verfügung stellt.

Der zu entfernende Teilbereich kann somit in einfacher Weise auch unter Berücksichtigung des darunter liegenden, ein Anhaften verhindernden Materials 6, 39 entfernt werden. Weiters kann, da eine aufwändige Durchtrennung der Rand- bzw. Kantenbereiche der zu entfernenden Teilbereiche nach einem Verbinden mit dem Core-Element 1, 19, 31 im Gegensatz zum Stand der Technik nicht erforderlich ist, auf die Ausbildung von zusätzlichen leitenden Schichten als Stoppschichten für ein Laserschneiden verzichtet werden. Ebenso kann auf die Verwendung von zusätzlichen Abdeckschichten zum Schutz von darunter liegenden Bauteilen insbesondere während des Entfernungsvorgangs des zu entfernenden Teilbereichs verzichtet werden. Weiters kann auch bei Einsatz von kostengünstigen, beispielsweise mit Verstärkungen versehenen Materialien jeweils ein genau definierter Rand- bzw. Kantenbereich insbesondere unter Verzicht auf einen Einsatz von Materialien, welche eine geringe Fließfähigkeit aufweisen, erzielt bzw. hergestellt werden.

## Patentansprüche

1. Verfahren zur Herstellung einer Leiterplatte, umfassend die folgenden Schritte:
- Bereitstellen wenigstens eines ersten, insbesondere mehrlagigen und gegebenenfalls teilweise strukturierten Elements (1, 19, 31), insbesondere eines mehrlagigen Core-Elements, der herzustellenden Leiterplatte,
- Aufbringen eines ein Anhaften verhindernden oder eines ein nachträgliches Entfernen erleichternden Materials (6,20,39) auf einem nach Anordnen wenigstens einer weiteren Lage (7, 7', 7", 40, 41, 40', 40",41', 41") freizulegenden Bereich des ersten Elements (1, 19, 31),
- Direktes Aufbringen der wenigstens einen weiteren Lage (7, 7', 7", 40, 41, 40', 40",41', 41") auf dem ersten Element (1, 19, 31), wobei die weitere Lage aus einem im Wesentlichen vollflächigen und insbesondere nicht-leitenden Material gebildet wird,
- Verbinden, beispielsweise Verpressen oder Laminieren des ersten Elements (1, 19, 31) und der wenigstens einen weiteren Lage (7, 7', 7", 40, 41, 40', 40",41', 41"), und
- Entfernen eines Teilbereichs (13, 44,45,44', 45') der weiteren Lage zur Freilegung des Bereichs des ersten Elements (1, 19, 31),
- wobei in der weiteren Lage (7, 7, 7", 40, 41, 40', 40", 41', 41") entsprechend dem nachfolgend zu entfernenden Teilbereich (13, 44, 45, 44', 45') an wenigstens einem Rand des zu entfernenden Teilbereichs (13, 44, 45, 44', 45') ein Durchtrennen des Materials der weiteren Lage (7, 7', 7", 40, 41, 40', 40",41', 41") vor einem Aufbringen auf das erste Element (1, 19, 31) und/oder Verbinden mit demselben durchgeführt wird,
- wobei das Material der weiteren Lage (7, 7', 7", 40, 41, 40', 40",41', 41") von einem mit einer Verstärkung ausgebildeten, fließfähigen Kunststoffmaterial, insbesondere einem mit Glasfasern verstärkten fließfähigen Kunststoffmaterial, beispielsweise einem Prepreg Material, gebildet wird,
- wobei der durchtrennte Bereich (11 , 12, 17, 18, 21, 48, 47, 46', 47') der weiteren Lage während des Verbindungsvorgangs mit dem ersten Element (1 , 19, 31) der Leiterplatte durch das fließfähige Kunststoffmaterial der an den durchtrennten Bereich (11, 12, 17, 18, 21, 48, 47, 46', 47') anschließenden Teilbereiche der weiteren Lage (7, 7', 7", 40, 41, 40', 40",41', 41") durch die während des Verbindungsvorgangs auftretenden Bedingungen erhöhter Temperatur und/oder erhöhten Drucks gefüllt wird.

2. Verfahren nach Anspruch 1, **dadurch gekennzeichnet, dass** wenigstens an zwei einander gegenüberliegenden Rändern des zu entfernenden, im Wesentlichen rechteckigen Teilbereichs (13, 44, 45, 44', 45') das Material der weiteren Lage (7, 7', 7", 40, 41, 40', 40",41', 41") durchtrennt wird.

3. Verfahren nach einem der Ansprüche 1 oder 2, **dadurch gekennzeichnet, dass** das Durchtrennen der weiteren Lage (7, 7' 7", 40, 41 , 40', 40", 41 ', 41") an wenigstens einem Rand des zu entfernenden Teilbereichs (13, 44, 45, 44', 45') durch ein Fräsen, Ritzen, Stanzen, Schlitzen, Schneiden, insbesondere Laserschneiden durchgeführt wird.

4. Verfahren nach einem der Ansprüche 1 bis 3, **dadurch gekennzeichnet, dass** nach einem Verbinden der weiteren Lage (7, 7', 7", 40, 41, 40', 40",41', 41 ") und des ersten Elements (1, 19, 31) der zu entfernende Teilbereich (13, 44, 45, 44', 45') durch ein Brechen des durchtrennten Bereichs (11, 12, 17, 18, 21 , 46, 47, 48', 47') der weiteren Lage entfernt wird.

5. Verfahren nach einem der Ansprüche 1 bis 4, **dadurch gekennzeichnet, dass** nach einem Verbinden der weiteren Lage (7, 7', 7") mit dem ersten Element das im durchtrennten Bereich der weiteren Lage angeordnete Material durch ein Schneiden (22), insbesondere ein Laserschneiden mit einem CO₂-Laser wenigstens teilweise durchtrennt wird.

6. Verfahren nach einem der Ansprüche 1 bis 5, **dadurch gekennzeichnet, dass** auf der weiteren Lage (7, 7', 7", 40, 41, 40', 40",41', 41 ") aus dem nicht-leitenden Material wenigstens eine Lage bzw. Schicht (8, 8', 8", 42, 43, 42', 42", 43', 43") aus einem leitenden, insbesondere strukturierten Material vorgesehen wird.

7. Verfahren nach einem der Ansprüche 1 bis 6, **dadurch gekennzeichnet, dass** das erste Element (31) der herzustellenden Leiterplatte von einem flexiblen Material zur Herstellung einer starr-flexiblen Leiterplatte gebildet, wird.

8. Verfahren nach einem der Ansprüche 1 bis 7, **dadurch gekennzeichnet, dass** das erste Element (31) auf beiden Oberflächen mit wenigstens einer weiteren Lage (40, 41, 40', 40", 41', 41") verbunden wird, wobei nachfolgend jeweils einander gegenüberliegende Teilbereiche (44, 45, 44', 45') der weiteren Lagen entfernt werden.

9. Verwendung eines Verfahrens nach einem der Ansprüche 1 bis 8, zur Herstellung einer mehrlagigen Leiterplatte.

10. Verwendung nach Anspruch 9, zur Erzeugung von Hohlräumen, insbesondere dreidimensionalen Hohlräumen bzw. Kavitäten in einer Leiterplatte.

11. Verwendung nach Anspruch 9, zur Erzeugung wenigstens eines Kanals in einer Leiterplatte.

12. Verwendung nach Anspruch 9, zur Freistellung wenigstens eines Elements, insbesondere Registrierelements, oder eines Bauteils im Inneren bzw. in Innenlagen einer mehrlagigen Leiterplatte.

13. Verwendung nach Anspruch 9, zur Herstellung von abgesetzten und/oder stufenförmigen ausgebildeten Teilbereichen einer Leiterplatte.

14. Verwendung nach Anspruch 9, zur Herstellung einer starr-flexiblen Leiterplatte.

## Claims

1. A method for the production of a circuit board, comprising the following steps:
- providing at least one first element, in particular a multi-layered and optionally partially structured element (1, 19, 31), in particular a multi-layered core element of the circuit board to be produced,
- applying a material (6, 20, 39) which prevents adhesion or facilitates subsequent removal to a region of the first element (1, 19, 31) to be exposed, after at least one further layer (7, 7', 7", 40, 41, 40', 40", 41', 41") has been put in place,
- directly applying the at least one further layer (7, 7', 7", 40, 41, 40', 40", 41', 41") to the first element (1, 19, 31), wherein the further layer is formed from a material which essentially covers the entire area and in particular is non-conductive,
- connecting, in particular pressing or laminating, the first element (1, 19, 31) and the at least one further layer (7, 7', 7", 40, 41, 40', 40", 41', 41"), and
- removing a portion (13, 44, 45, 44', 45') of the further layer in order to expose the region of the first element (1, 19, 31),
- wherein in the further layer (7, 7', 7", 40, 41, 40', 40", 41', 41"), severing of the material of the further layer (7, 7', 7", 40, 41, 40', 40", 41', 41") is carried out so as to match the portion (13, 44, 45, 44', 45') to be subsequently removed, on at least one edge of the portion (13, 44, 45, 44', 45') to be removed prior to application to the first element (1, 19, 31) and/or any connection therewith,
- wherein the material of the further layer (7, 7', 7", 40, 41, 40', 40", 41', 41") is formed by a fluid plastic material configured with a reinforcement, in particular a fluid plastic material reinforced with glass fibres, for example a prepreg material,
- wherein, during the connection procedure with the first element (1, 19, 31) of the circuit board, the severed region (11, 12, 17, 18, 21, 48, 47, 46', 47') of the further layer is filled by the fluid plastic material of the portions of the further layer (7, 7', 7", 40, 41, 40', 40", 41', 41") that follow the severed region (11, 12, 17, 18, 21, 48, 47, 46', 47') because of the elevated temperature and/or elevated pressure which occurs during the connection process.

2. The method as claimed in claim 1, **characterized in that** the material of the further layer (7, 7', 7", 40, 41, 40', 40", 41', 41") is severed on at least two edges of the essentially rectangular portion (13, 44, 45, 44', 45') to be removed which lie opposite one another.

3. The method as claimed in claim 1 or claim 2, **characterized in that** severing of the further layer (7, 7' 7", 40, 41, 40', 40", 41', 41") is carried out on at least one edge of the portion (13, 44, 45, 44', 45') to be removed, by means of milling, scoring, punching, slitting, cutting, in particular laser cutting.

4. The method as claimed in one of claims 1 to 3, **characterized in that** after the further layer (7, 7', 7", 40, 41, 40', 40", 41', 41") and the first element (1, 19, 31) have been connected, the portion to be removed (13, 44, 45, 44', 45') is removed by breaking the severed region (11, 12, 17, 18, 21, 46, 47, 48', 47') of the further layer.

5. The method as claimed in one of claims 1 to 4, **characterized in that** after the further layer (7, 7', 7") has been connected with the first element, the material disposed in the severed region of the further layer is severed, at least in part, by means of cutting (22), in particular by laser cutting using a CO₂ laser.

6. The method as claimed in one of claims 1 to 5, **characterized in that** at least one layer or ply (8, 8', 8", 42, 43, 42', 42", 43', 43") composed of a conductive, in particular a structured material, is provided on the further layer (7, 7', 7", 40, 41, 40', 40", 41', 41") composed of the non-conductive material.

7. The method as claimed in one of claims 1 to 6, **characterized in that** the first element (31) of the circuit board to be produced is formed by a flexible material for the production of a rigid-flexible circuit board.

8. The method as claimed in one of claims 1 to 7, **characterized in that** the first element (31) is connected, on both surfaces, with at least one further layer (40, 41, 40', 40", 41', 41"), wherein subsequently, portions (44, 45, 44', 45') of the further layers which respectively lie opposite one another are removed.

9. Use of a method as claimed in one of claims 1 to 8, for the production of a multi-layered circuit board.

10. Use according to claim 9, for the production of cavities, in particular three-dimensional cavities or voids, in a circuit board.

11. Use according to claim 9, for the production of at least one channel in a circuit board.

12. Use according to claim 9, for exposing at least one element, in particular a register element, or a component in the interior or in inner plies of a multi-layered circuit board.

13. Use according to claim 9, for the production of portions of a circuit board configured to be set back and/or step-shaped.

14. Use according to claim 9, for the production of a rigid-flexible circuit board.

## Revendications

1. Procédé, destiné à produire une carte de circuits imprimés, comprenant les étapes suivantes, consistant à :
- mettre à disposition au moins un premier élément (1, 19, 31), notamment multicouches et le cas échéant partiellement structuré, notamment un élément central de la carte de circuits imprimés qui doit être produite,
- appliquer une matière (6, 20, 39) empêchant une adhérence ou facilitant un retrait ultérieur sur une zone du premier élément (1, 19, 31) qui doit être mise à nu après le placement d'au moins une couche (7, 7', 7", 40, 41, 40', 40", 41', 41") supplémentaire,
- appliquer directement l'au moins une couche (7, 7', 7", 40, 41, 40', 40", 41', 41") supplémentaire sur le premier élément (1, 19, 31), la couche supplémentaire étant formée d'une matière sensiblement à pleine surface et notamment non conductrice,
- assembler, par exemple compresser ou laminer le premier élément (1, 19, 31) et l'au moins une couche (7, 7', 7", 40, 41, 40', 40", 41', 41") supplémentaire, et
- retirer une zone partielle (13, 44, 45, 44', 45') de la couche supplémentaire, pour mettre à nu la zone du premier élément (1, 19, 31),
- dans la couche (7, 7', 7", 40, 41, 40', 40", 41', 41") supplémentaire étant procédé, en fonction de la zone partielle (13, 44, 45, 44', 45') qui doit être retirée par la suite, sur au moins un bord de la zone partielle (13, 44, 45, 44', 45') qui doit être retirée à un sectionnement de la matière de la couche (7, 7', 7", 40, 41, 40', 40", 41', 41") supplémentaire, avant une application sur le premier élément (1, 19, 31) et/ou un assemblage avec celui-ci,
- la matière de la couche (7, 7', 7", 40, 41, 40', 40", 41', 41") supplémentaire étant formée d'une matière plastique fluide, conçue avec un renfort, notamment d'une matière plastique fluide renforcées par fibres de verre, par exemple d'une matière pré-imprégnée,
- pendant le processus d'assemblage, la zone (11, 12, 17, 18, 21, 48, 47, 46', 47') sectionnée de la couche supplémentaire étant remplie par le premier élément (1, 19, 31) de la carte de circuits imprimés par la matière plastique fluide des zones partielles de la couche (7, 7', 7", 40, 41, 40', 40", 41', 41") supplémentaire qui sont adjacentes à la zone (11, 12, 17, 18, 21 , 48, 47, 46', 47') sectionnée par les conditions de température élevée et/ou de pression élevée se produisant pendant le processus d'assemblage.

2. Procédé selon la revendication 1, **caractérisé en ce qu'**au moins sur deux des bords opposés de la zone partielle (13, 44, 45, 44', 45') sensiblement rectangulaire qui doit être retirée, on sectionne la matière de la couche (7, 7', 7", 40, 41, 40', 40", 41', 41") supplémentaire.

3. Procédé selon l'une quelconque des revendications 1 ou 2, **caractérisé en ce qu'**on procède au sectionnement de la couche (7, 7' 7", 40, 41, 40', 40", 41', 41") supplémentaire sur au moins un bord de la zone partielle (13, 44, 45, 44', 45') qui doit être retirée par un fraisage, une gravure, un estampage, un refendage, une coupe, notamment une coupe au laser.

4. Procédé selon l'une quelconque des revendications 1 à 3, **caractérisé en ce qu'**après un assemblage de la couche (7, 7', 7", 40, 41, 40', 40", 41', 41") supplémentaire et du premier élément (1, 19, 31), on retire la zone partielle (13, 44, 45, 44', 45') qui doit être retirée par une rupture de la zone (11, 12, 17, 18, 21, 46, 47, 48', 47') sectionnée de la couche supplémentaire.

5. Procédé selon l'une quelconque des revendications 1 à 4, **caractérisé en ce qu'**après un assemblage de la couche (7, 7', 7") supplémentaire et du premier élément, on sectionne au moins partiellement la matière placée dans la zone sectionnée de la couche supplémentaire par une coupe (22), notamment une coupe au laser avec un laser CO₂.

6. Procédé selon l'une quelconque des revendications 1 à 5, **caractérisé en ce qu'**on prévoit sur la couche (7, 7', 7", 40, 41, 40', 40", 41', 41") supplémentaire constituée de la matière non conductrice au moins une couche ou enduction (8, 8', 8", 42, 43, 42', 42", 43', 43") d'une matière conductrice, notamment structurée.

7. Procédé selon l'une quelconque des revendications 1 à 6, **caractérisé en ce qu'**on forme le premier élément (31) de la carte de circuits imprimés qui doit être produite en une matière flexible, pour la production d'une carte de circuits imprimés rigide et flexible.

8. Procédé selon l'une quelconque des revendications 1 à 7, **caractérisé en ce qu'**on assemble sur les deux surfaces le premier élément (31) avec au moins une couche (40, 41, 40', 40", 41', 41") supplémentaire, par la suite, chaque fois des zones partielles (44, 45, 44', 45') mutuellement opposées des couches supplémentaires étant retirées.

9. Utilisation d'un procédé selon l'une quelconque des revendications 1 à 8, pour la production d'une carte de circuits imprimés multicouches.

10. Utilisation selon la revendication 9, pour générer des espaces creux, notamment des espaces creux ou cavités tridimensionnel(le)s dans une carte de circuits imprimés.

11. Utilisation selon la revendication 9, pour générer au moins un canal dans une carte de circuits imprimés.

12. Utilisation selon la revendication 9, pour mettre à nu au moins un élément, notamment un élément d'enregistrement ou un composant à l'intérieur ou dans des couches internes d'une carte de circuits imprimés multicouches.

13. Utilisation selon la revendication 9, pour produire des zones partielles déportées et / ou échelonnées d'une carte de circuits imprimés.

14. Utilisation selon la revendication 9, pour la production d'une carte de circuits imprimés rigide et flexible.
